# EUROPEAN PATENT APPLICATION

(11) **EP 4 749 393 A1**
(43) Date of publication of application: **27.05.2026**
(21) Application number: 23945468.9
(22) Date of filing: 19.07.2023
(51) Int. Cl.: G06F 1/20

(54) **CASE HEAT DISSIPATION DEVICE HAVING HEAT PIPES AND COOLING FINS, AND CASE**

(71) Applicant: Bitdeer Semiconductor Technology PTE. LTD., 049514 Singapore (SG)
(72) Inventor: SUN, Wenzhong, Hong Kong (CN); LIU, Xingyong, Hong Kong (CN)
(74) Representative: Metida
(86) International application number: PCT/CN2023/108259
(87) International publication number: WO 2025/015578

(57) **Abstract**

The present invention provides a chassis heat dissipation device with a heat pipe heat dissipation fin, and a chassis having the same, wherein the chassis heat dissipation device comprises at least one heat sink placed on and under each circuit board, the heat sink comprises a top heat sink and a bottom heat sink, each heat sink comprises a plurality of rows of heat dissipation fins, the heat dissipation fin forms a vertical angle with the circuit board, the top heat sink and bottom heat sink sandwich the circuit board in between and are locked by screws into an integrated whole, and the heat of the computing power units is transferred to the heat dissipation fin and carried away by the flowing air; the heat sink is correspondingly placed on each column of chips of the computing power unit, heat pipes are embedded in the heat sink, a thermally conductive silicone grease is filled between the chips and the heat pipes to ensure sufficient connection, and heat pipes and the heat sink are connected by soldering; the heat pipes are evenly embedded in rows in the heat dissipation fin; the heat dissipation fin and heat pipes are made of different materials; the heat pipes have a convex cross section; the heat pipes embedded in the top heat sink and bottom heat sink are arranged in a crossed manner. The present invention can improve the heat dissipation capability of the whole machine and solve the problem about uneven temperature distribution of the whole machine.

## Description

### FIELD

The present invention relates to the field of computer technologies, and particularly to a chassis heat dissipation device with a heat pipe heat dissipation fin, and a chassis having the same.

### BACKGROUND

In the prior art, with the rapid development of technologies such as AI, the influence of the virtual network era has become increasingly far-reaching. The demand for computers with robust computing power is also growing daily, especially for computers where a hash computing power serves as a core indicator, such as Bitcoin miners, wherein the higher the computing power, the higher the returns. Driven by this goal, Bitcoin miner manufacturers improve the computing power in various ways to improve the core competitiveness of products. However, as the computing power increases, the power consumption of the whole machine also rises, making heat dissipation a critical issue to be addressed.

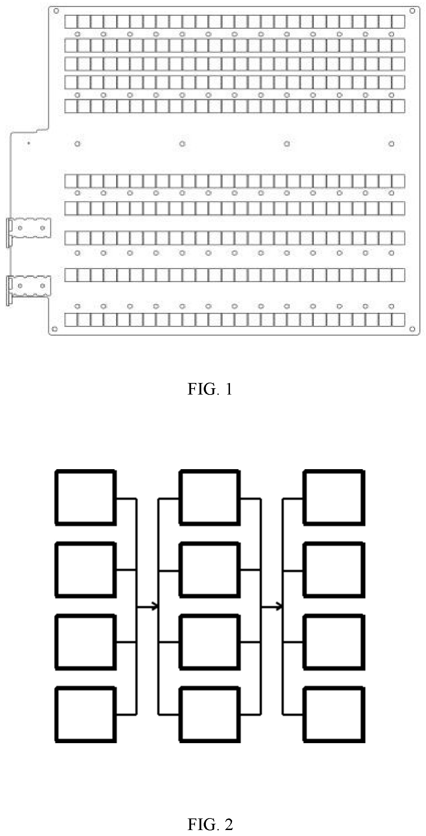

To achieve a higher computing power, a plurality of computing power units are usually integrated in one Bitcoin miner, and many chips are integrated in each unit, as shown in FIG. 1. Multiple chips are directed into one group (five chips are in one group, and there are totally 52 groups as shown in FIG. 1) and coupled as one small unit, small units are coupled in series via wiring, an entire circuit board is powered through terminals on the left side, one terminal serves as a positive electrode and the other terminal serves as a negative electrode, forming a loop with all small units, as shown in FIG. 2. Each unit is evenly allocated an input voltage, i.e. Vunit=Vin/N, where N is the number of units. The operating voltage distributed to each unit must be the same to ensure the entire circuit loop stable. Otherwise, the misbalance in the distribution of the voltage will cause chips to operate at a reduced frequency and cause loss of the computing power, and, in serious cases, directly cause the direct breakdown of the loop and abnormal operation of the machine. However, in order to ensure each unit is distributed the same operating voltage Vunit, all chips are required to operate in the same state, the same state comprising:
1. The same operating frequency.
2. The same operating temperature.

The same operating frequency may be ensured by a software setting and be achieved very easily. However, the same operating temperature is generally difficult to achieve.

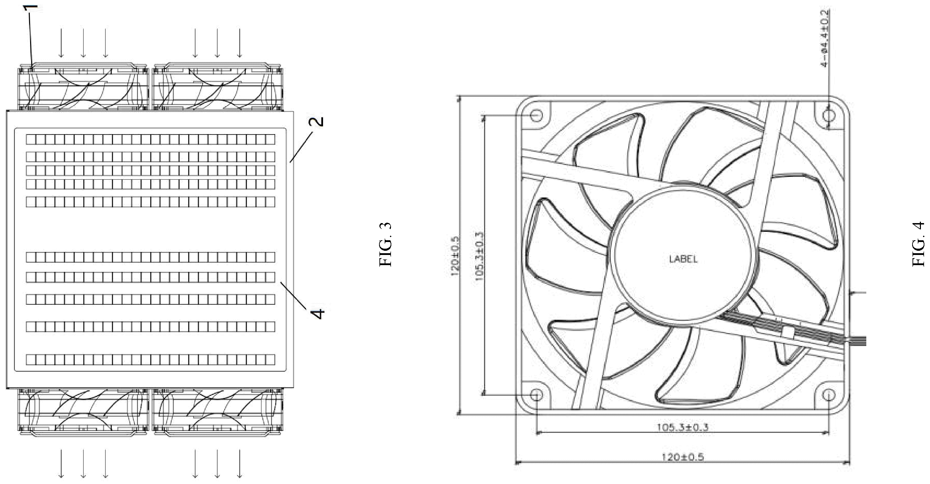

The cooling manner of the conventional computing devices employs a forced air-cooling technique as shown in FIG. 3. Air is pressed by axial flow fans into the chassis body from the right side, and drawn out of the chassis body by the fans on the left side. The chips adjacent to the right side receive cold air that just enters the chassis body, whereas the chips adjacent to the left side receive air already heated by the chips on the right side, which causes the chips adjacent to the left side and right side at inconsistent temperatures. Under the same heat dissipation condition, the temperature of the chips on the left side is higher than that of the chips on the right side, thereby causing the operating voltage of the units offset, and thereby making it necessary to balance the temperature by reducing the power and further reducing the generated heat by reducing the frequency of the chips on the left side, thereby causing the loss of the computing power.

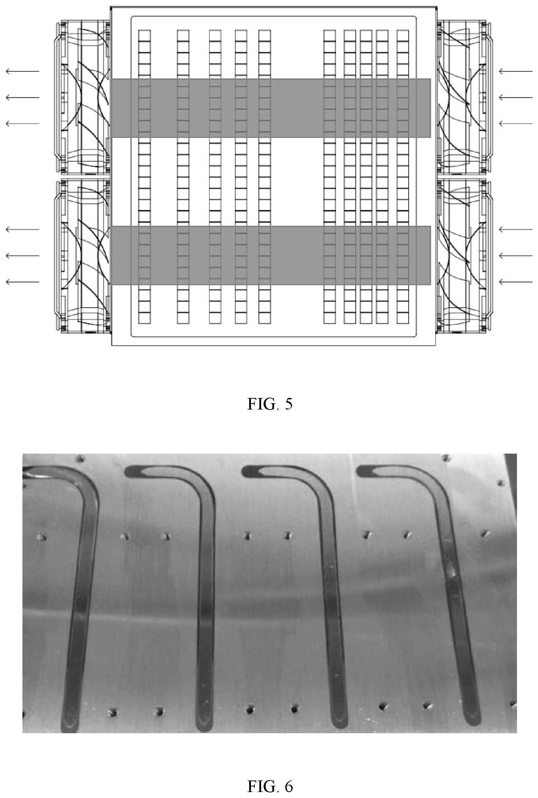

In addition, as shown in FIG. 4, since the fans each have a shaft at the center, due to the problem about the central shafts, the chips in regions projected by the centers of the fans such as the shaded regions as shown in FIG. 5 receive less air, less heat is carried away from the chips, and the temperature of the chips in the shaded regions is higher than that of the chips in the non-shaded regions, so that it is necessary to achieve the consistent temperature by reducing the operating frequency of the chips in the shaded regions and reducing the generated heat, so that the loss of the computing power is caused.

A conventional technical solution usually reduces the temperature difference on the left and right sides by arranging the chips more densely at an air inlet and chips more sparsely at an air outlet. However, the actual effect is limited, and it is usually still necessary to reduce the frequency of the chips in the high-temperature region to be consistent with the frequency of the low-temperature region to ensure the stability of the circuit, but reducing the frequency directly causes the loss of the computing power of the whole machine.

To address the heat dissipation problem, currently many manufacture begin to develop a liquid-cooling manner, i.e., immersing the circuit board in oil. Since the heat-conducting capability of oil is much greater than air, the power of the whole machine can be improved. However, this solution is usually complex in terms of design and production and of a very high cost, and is not actually deployed in a large amount.

Therefore, the prior art employs the following solution for improvements:
1. Using the forced air-cooling technique, providing axial flow fans at both ends of the machine to dissipate heat, enhancing an air flow rate by increasing the rotation speeds of the fans, and improving the heat exchange capability to improve the heat dissipation capability.
2. Enlarging the size of the fans to thereby increasing the air ingress cross section, and synchronously increasing the size of the heat sinks and increasing the heat exchange area to thereby improve the heat dissipation capability.
3. Using an aluminum-based PCB to reduce the thermal resistance to thereby improve the heat dissipation capability.
4. Using a silicone grease with a high coefficient of thermal conductivity to fill the gaps between the chips and the heat sinks, and between the PCB and the heat sinks, thus reducing the thermal resistance and improving the heat-conducting capability.

However, the prior art still has the following problems:
1. Currently, for example Bitcoin miners substantially employ the forced air-cooling technique. Due to the limitations of the rotation speed of the fans, it is already very difficult to improve the heat dissipation capability by increasing the rotation speed of the fans.
2. Since there are many chips on a single board and cold air travels a certain distance from the air inlet to the air outlet, air is forced into the chassis housing by the fans, and then exchanges heat sequentially with the front-row chips and then the rear-row chips, and is finally discharged out of the chassis housing. There arises a case in which the air temperature rises gradually, so the temperature of the single board is also in a gradually-rising distribution. Such a distribution causes the problems that the temperature at the air inlet is too low, the operating frequency is too low, the computing power gets lost, and the temperature of the chips at the air outlet is too high, causing a reduction in reliability.
3. As viewed from the characteristics of the fans, the air volume at the central shaft positions and edges of the fans is small, the air volume at fan blade projection surfaces is large, which also causes uneven temperature on the left side and right side of the single board.

In addition, technical terms often used in the prior art include the following:
Heat pipe: it is hollow in the interior and made of a thermally conductive material having a coefficient of thermal conductivity up to 20000W/m.k~200000W/m.k, whereas the coefficient of thermal conductivity of an ordinary aluminum material is 200W/m.k, as shown in FIG. 6.

### SUMMARY

To solve the above problem, an object of the present application is to optimize the heat dissipation, and ensure heat Q dissipated by each unit via a heat dissipation system is substantially equal. The object of the present invention is to, by optimizing the heat dissipation, ensure the stability of the machine, enable operation at the highest computing power level, achieve the highest output, improve the heat dissipation capability of the whole machine, and solve the problem about uneven temperature distribution of the whole machine.

Specifically, the present invention provides a chassis heat dissipation device with a heat pipe heat dissipation fin, the device comprising: at least two axial flow fans distributed on both sides of a chassis housing, a chassis housing in which a computing power unit is received, and a least one computing power unit, each computing power unit comprising at least one circuit board, each computing power unit integrating a plurality of chips, the plurality of chips being arranged side by side, multiple chips being directed into one group and coupled as one small unit, small units being coupled in series via wiring to form the circuit board, wherein at least one heat sink is placed on and under said each circuit board, the heat sink located on an upper side of the circuit board is a top heat sink, the heat sink located on a lower side of the circuit board is a bottom heat sink, said each heat sink includes a plurality of rows of heat dissipation fins arranged in parallel, front ends of the top and bottom heat sinks are respectively at an outwardly chamfered angle, the angle is in a range of 20~50 degrees, the heat dissipation fin forms a vertical angle with the circuit board, the top heat sink directly presses against the chips on the circuit board, and the circuit board is directly placed on the bottom heat sink so that the circuit board is sandwiched between the top heat sink and the bottom heat sink, the heat dissipation fins and the circuit board in between are pressed and locked into one piece by spring screws, each chip on the circuit board is an independent heat generating unit, and the heat of the computing power unit is transferred to the heat dissipation fins and carried away by the flowing air;
the heat sink is placed correspondingly on all chips of the computing power unit, grooves having the same dimensions as the heat pipes are machined in the bottom of the heat sink by CNC milling, the heat sink is electroplated to ensure solderability, a layer of solder paste is applied into the grooves, the heat pipes are placed into the grooves, the heat pipes and the grooves are soldered into an integrated whole through high-temperature soldering, and then the bottom surface of the heat sink is milled flat to ensure that the bottom of the heat pipe and the bottom of the heat sink are flat and even; the heat pipes of the heat sink are placed on the chips; the chips are connected to the heat pipes via a thermally conductive silicone grease which is filled into gaps between the heat pipes and the chips and gaps between the heat pipes and the circuit board, to ensure full contact between the chips and the heat sink; the heat pipes are soldered with the heat sink into an integrated whole;
the heat pipes are evenly embedded in rows into the heat dissipation fins; the heat dissipation fins and the heat pipes are made of different materials;
the heat pipes assume a shape with a convex cross section; since a coefficient of thermal conductivity of the heat pipes is greater, the convex shape can increase a convex surface, i.e., increase a contact surface, on the basis of the heat pipe having an original thickness, and meanwhile a stepped groove hole fixes the position of the heat pipe more easily so that the heat pipe is not apt to deviate during the soldering and can stably carry more heat Q to the heat dissipation fins;
the heat pipes embedded in the top heat sink and bottom heat sink are arranged in a crossed manner, i.e., after the top and bottom heat sinks sandwich the circuit board, the temperatures of all chips can be made uniform in different cross directions at the same time.

The heat of each chip of the computing power unit is transferred to the top heat sink and carried away by the flowing air; the heat of each chip is transferred via the circuit board to the bottom heat sink and carried away by air.

The placing the heat pipes of the heat sinks on the chips comprises correspondingly placing the top heat sink and the bottom heat sink respectively above each column/row of chips of the computing power unit, subjecting a bottom surface of the top heat sink and a bottom surface of the bottom heat sink, which respectively contact the circuit board, to an electroplating process, and enabling to heat pipes of the top heat sink to be placed exactly above the chips; the heat pipes of the bottom heat sink are evenly distributed exactly below the chips.

The heat dissipation fin is made of aluminum, and a coefficient of thermal conductivity k of aluminum is 200W/m.k.

The heat pipes are made of copper, and a coefficient of thermal conductivity k of copper is in a range of 20000W/m.k~200000W/m.k, which is 100 to 1000 times the coefficient of thermal conductivity of aluminum, and the heat pipes make the temperature difference on the chips uniform quickly and can carry more heat to the heat dissipation fin made of aluminum.

At least one heat pipe soldered to the bottom of the heat sink extends from one side thereof and is bent along the edge of the heat sink and then inserted back into heat dissipation fins; a perforation is reserved at a middle portion of a lateral side of the heat dissipation fins to allow the bent heat pipe to be inserted therein; since the heat dissipation fin has a certain height, a temperature difference exists between its top and bottom, and the temperature at the top is lower; the heat pipe bent and inserted back into the heat dissipation fins can carry heat to a low-temperature region closer to the top of the heat dissipation fins.

The heat pipe is bent into the heat sink in a U-shape, with one side of the U-shape being located at the bottom of the heat sink in contact with the chips and the other side of the U-shape being located in the heat dissipation fin.

The arranging the heat pipes embedded in the top heat sink and bottom heat sink in a crossed manner comprises: arranging the heat pipes of the top heat sink in a horizontal direction and arranging the heat pipes of the bottom heat sink in a vertical direction to carry heat away from the heat dissipation fins in the horizontal direction and vertical direction, respectively;
arranging the heat pipes of the top heat sink in the vertical direction and arranging the heat pipes of the bottom heat sink in the horizontal direction; and arranging the heat pipes of the top heat sink and the heat pipes of the bottom heat sink in any two cross directions, to enable the heat pipes on the two heat sinks to make the temperature get uniform in different directions.

The present invention further comprises a chassis with a heat pipe heat dissipation fin, wherein the chassis heat dissipate device described above may be applied to the chassis, and the chassis further comprises:
a support for supporting and fixing a chassis housing, fans, an upper cover, computing power units and the chassis heat dissipation device, wherein the upper cover and the chassis housing constitute a chassis outer contour via the support;
the chassis heat dissipation device and various electronic elements are received in the chassis housing;
a power supply module located beside the fan on one side and connected with a circuit board and a control module in the chassis;
a control module placed on the support and located above the chassis housing and below the upper cover and configured to control the electronic elements in the chassis;
the chassis heat dissipation device and the computing power units are located behind the fans to facilitate heat dissipation.

Thus, the advantages of the present application lie in that, by adding heat pipes into standard heat sinks in the industry and integrating the heat pipes and heat sinks in a specific manner, the present applicant can effectively solve the problems such as uneven temperatures and insufficient heat dissipation capability, meanwhile reduce the cost and facilitate the production and deployment.

### BRIEF DESCRIPTION OF THE DRAWINGS

The figures described here are used to provide further understanding of the present invention, constitute a part of the present application, and are not construed as limiting the present invention.
FIG. 1 is a schematic view of a layout of chips on a circuit board in the prior art.
FIG. 2 is a schematic view of serial power supply to the chips in the prior art.
FIG. 3 is a schematic view of a cooling manner of a conventional computing device in the prior art.
FIG. 4 is a schematic view of fans for a chassis housing in the prior art.
FIG. 5 is a schematic view of a distribution of an air amount received by the chassis housing in the prior art.
FIG. 6 is a schematic view of heat pipes in the prior art.
FIG. 7 is a schematic view of a computing unit and a heat sink in an embodiment of the present application.
FIG. 8 is a perspective view showing that a circuit board is sandwiched by a top heat sink and a bottom heat sink in an embodiment of the present application.
FIG. 9 is a side view showing that a circuit board is sandwiched by a top heat sink and a bottom heat sink in an embodiment of the present application.
FIG. 10 is a schematic view of a top heat sink and heat pipes in an embodiment of the present application.
FIG. 11 is a cross-sectional view of heat dissipation fins and heat pipes in an embodiment of the present application.
FIG. 12 is a schematic view of a bottom heat sink and heat pipes in an embodiment of the present application.
FIG. 13 is a schematic view of a U-shaped heat pipe in an embodiment of the present application.
FIG. 14 is a schematic view of interleaved heat pipes of a top heat sink and a bottom heat sink in an embodiment of the present application.
FIG. 15 is a schematic view of an external view of a chassis according to an embodiment of the present application.
FIG. 16 is an exploded view of a chassis according to an embodiment of the present application.
FIG. 17 is an exploded view of a heat dissipation device and a chassis in the present application.

### DETAILED DESCRIPTION OF EMBODIMENTS

The present invention will be described in more detail with reference to the figures to make technical content and advantages of the present invention more apparent.

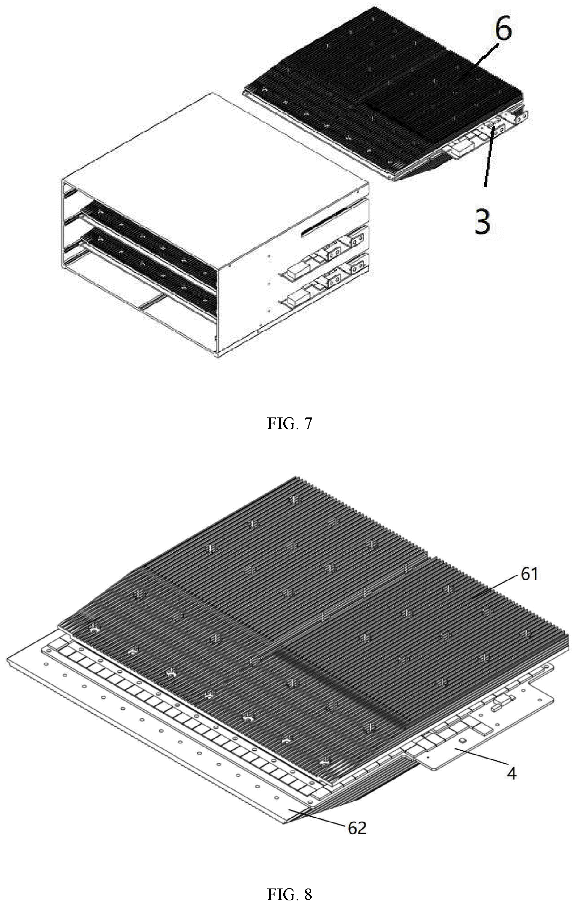

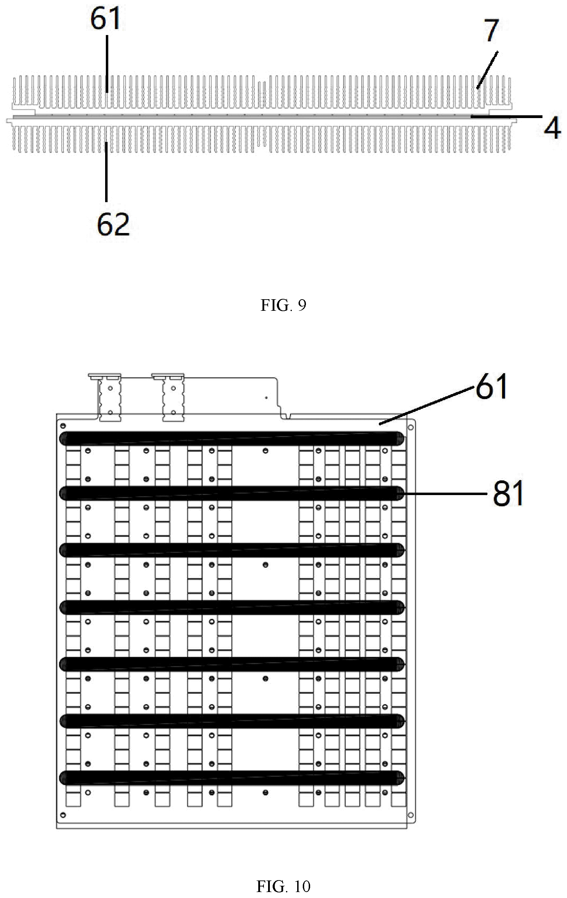

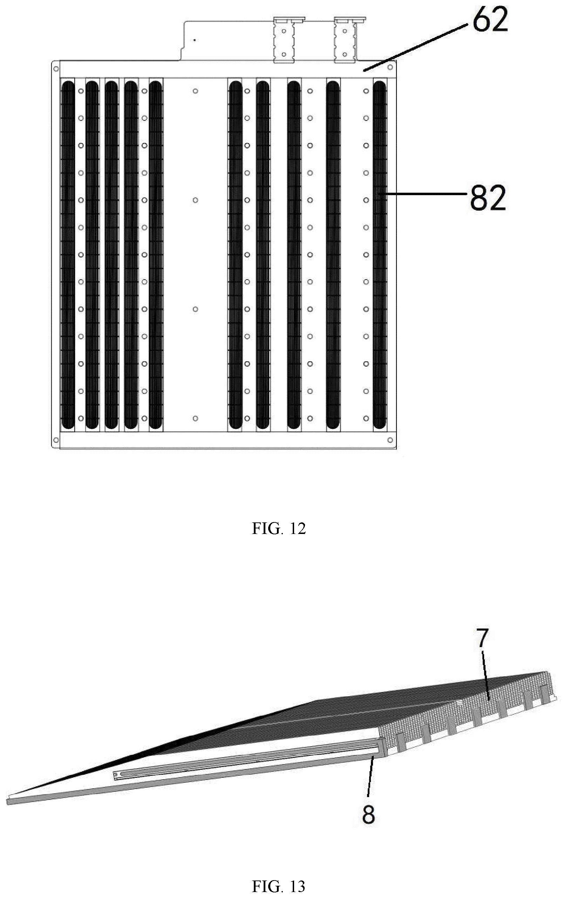

As shown in FIG. 7 through FIG. 14, the present application designs a chassis heat dissipation device, particularly one with heat pipe heat dissipation fins, particularly to enhance and improve the heat dissipation capability of Bitcoin miners. The device comprises:
at least two axial flow fans 1 distributed on both sides of a chassis housing 2, a chassis housing 2 in which a computing power unit 3 is received, and a least one computing power unit 3, wherein each computing power unit 3 comprises at least one circuit board 4, each computing power unit 3 integrates a plurality of chips 5, the plurality of chips 5 are arranged side by side, multiple chips are directed into one group and coupled as one small unit, small units are coupled in series via wiring to form the circuit board 4, at least one heat sink 6 is placed on and under said each circuit board 4, the heat sink located on an upper side of the circuit board is a top heat sink 61, the heat sink located on a lower side of the circuit board is a bottom heat sink 62, said each heat sink 6 includes a plurality of rows of heat dissipation fins 7 arranged in parallel, front ends of the top and bottom heat sinks are respectively at an outwardly chamfered angle, and the angle is in a range of 20~50 degrees; the top heat sink 61 directly presses against the chips on the circuit board 4, and the circuit board 4 is directly placed on the bottom heat sink 62 so that the circuit board 4 is sandwiched between the top heat sink 61 and the bottom heat sink 62; the heat dissipation fins 7 and the circuit board in between are pressed and locked into an integrated whole by spring screws 7, wherein the spring screws can effectively prevent screws from becoming loose after long-term use and can also prevent the chips on the circuit board from damages when the circuit board is locked tightly;
Each chip on the circuit board is an independent heat generating unit, and the heat of the computing power unit 3 is transferred to the heat dissipation fins 7 and carried away by the flowing air; that is, the heat of each chip of the computing power unit 3 is transferred to the top heat sink 61 and carried away by the flowing air; the heat of each chip is transferred via the circuit board to the bottom heat sink 62 and carried away by air;
The heat sink 6 is placed correspondingly on all chips 5 of the computing power unit 3, as shown in FIG. 10 and FIG. 12. For ease of clear illustration, the figures do not show the heat dissipation fins. The top heat sink 61 and the bottom heat sink 62 are respectively placed above each column/row of chips 5 of the computing power unit 3 correspondingly; a bottom surface of the top heat sink 61 and a bottom surface of the bottom heat sink 62, which respectively contact the circuit board 4, are subjected to an electroplating process, heat pipes 81 of the top heat sink 61 are placed exactly above the chips 5, and heat pipes 82 of the bottom heat sink 62 are evenly distributed exactly below the chips;
Grooves having the same dimensions as the heat pipes 8 are machined in the bottom of the heat sink 6 by CNC milling, the heat sink 6 is electroplated to ensure solderability, a layer of solder paste is applied into the grooves, the heat pipes 8 are placed into the grooves, the heat pipes 8 and the grooves are soldered into an integrated whole through high-temperature soldering, and then the bottom surface of the heat sink 6 is milled flat to ensure the bottom of the heat pipe 8 and the bottom of the heat sink 6 flat and even; the heat pipes 8 of the heat sink 6 are placed on the chips 5; the chips 5 are connected to the heat pipes 8 via a thermally conductive silicone grease which is filled into gaps between the heat pipes and the chips and gaps between the heat pipes and the circuit board 4, to ensure full contact between the chips and the heat sink; the heat pipes 8 are soldered with the heat sink 6 into an integrated whole;
The heat pipes 8 are evenly embedded in rows into the heat dissipation fins 7;
The heat dissipation fins 7 and the heat pipes 8 are made of different materials; the heat pipes assume a shape with a convex cross section; since the coefficient of thermal conductivity of the heat pipes is greater, the convex shape can increase a convex shape, i.e., increase the contact surface on the basis of the heat pipe having an original thickness, and meanwhile a stepped groove hole fixes the position of the heat pipe more easily so that the heat pipe is not apt to deviate during the soldering and can stably carry more heat Q to the heat dissipation fins;
The heat pipes 8 embedded in the top heat sink 61 and bottom heat sink 62 are arranged in a crossed manner, i.e., after the top and bottom heat sinks sandwich the circuit board, the temperatures of all chips can be made uniform in different cross directions at the same time.

As shown in FIG. 10, the top heat sink 61 is correspondingly above each column of chips 5, the heat pipes 8 are embedded in the heat sink, the chips 5 are linked to the heat pipes 8 via a thermally conductive silicone grease, and the heat pipes 8 are connected to the heat sink 6 by soldering. Given that the heat pipes 8 employ copper pipes whose coefficient of thermal conductivity k is in a range of 20000W/m.k~200000W/m.k and is 100 to 1000 times the coefficient of thermal conductivity 200W/m.k of aluminum, and according to the thermal conduction equation Q=kA(ΔT/L), where Q represents heat, k represents the coefficient of thermal conductivity, A represents a heat transfer area, ΔT represents a temperature difference, and L represents a heat conduction distance, it can be known from above that ΔT=QL/kA. The temperature difference is inversely proportional to the coefficient of thermal conductivity, and a larger k may make the temperatures of different regions uniform quickly. The heat pipes 8 in this direction may make the difference of temperatures of the chips for example in the horizontal direction uniform, i.e., solve the problem about an excessively high temperature in the fan projection regions. Meanwhile, according to the thermal conduction equation, the larger k can also enable more heat Q to be carried onto the aluminum heat dissipation fins 7, i.e., the heat can be conducted onto the heat dissipation fins 7 quickly through the copper pipes having the high coefficient of thermal conductivity, thereby enabling air to carry away more heat and thereby improving the heat dissipation capability of the whole machine.

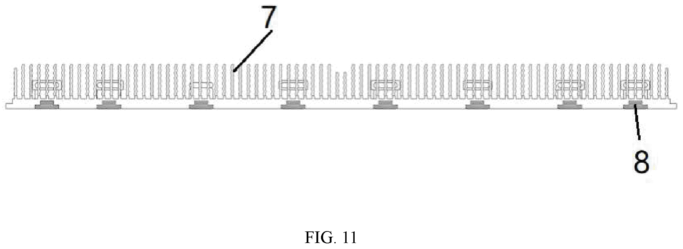

As shown in FIG. 11, the copper pipe 8 employs a convex state; as the coefficient of thermal conductivity of the copper pipe 8 is higher, the convex shape can increase the area of contact between the copper pipe and the heat sink; it is known from the Equation Q=kA(ΔT/L) that a larger heat transfer area enables more heat Q to be carried onto the aluminum heat dissipation fins 7, thereby improving the overall heat dissipation capability, reducing the temperature of the chips (heat sources) under equal conditions, and thereby making the whole machine more stable and have a larger room of improving the frequency.

As shown in FIG. 12, heat pipes 8 in the vertical direction are embedded in the bottom heat sink 62, and the heat pipes 8 are evenly embedded in the heat sink 6; likewise, according to the equation ΔT=QL/kA, the difference of temperatures of the chips in the vertical direction can also be made uniform quickly. Meanwhile, according to the thermal conduction equation, the larger k can also enable more heat Q to be carried onto the aluminum heat dissipation fins 7, thereby enabling air to carry away more heat and thereby improving the heat dissipation capability of the whole machine.

As shown in FIG. 13, furthermore, in order to achieve a better heat dissipation effect, at least one heat pipe (the number is optional, one, several, or all) soldered to the bottom of the heat sink extends from one side thereof and is bent along the edge of the heat sink and then inserted back into heat dissipation fins; a perforation is reserved at a middle portion of a lateral side of the heat dissipation fins to allow the bent heat pipe to be inserted therein; since the heat dissipation fin has a certain height, a temperature difference exists between its bottom and top, and the temperature at the top is lower; the heat pipe bent and inserted back into the heat dissipation fins can carry heat to a low-temperature region closer to the top of the heat dissipation fins. As such, a larger temperature difference may achieve a better heat dissipation capability.

Especially, at least one heat pipe 8 is bent into the heat sink in a U-shape as viewed from the side, with one side of the U-shape being located at the bottom of the heat sink in contact with the chips and the other side of the U-shape being located in the heat dissipation fin.

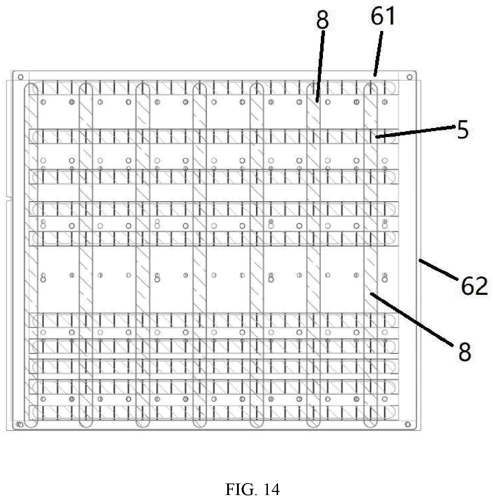

As shown in FIG. 14, after the top heat sink 61 and bottom heat sink 62 sandwich the circuit board 4, the temperatures of all computing power chips 5 can be made uniform in the cross directions, i.e., the horizontal direction and vertical direction, simultaneously, so that the temperatures of all units of the whole machine are substantially consistent, thereby avoiding the occurrence of the case wherein the operating frequency is forcedly reduced to decrease the heat to achieve consistent temperatures, and meanwhile ensuring the stability in the operation of the circuit board 4. In addition to arranging the heat pipes of the top heat sink in the horizontal direction and arranging the heat pipes of the bottom heat sink in the vertical direction to carry heat away from the heat dissipation fins in the horizontal direction and the vertical direction, respectively, the arrangement further comprises: arranging the heat pipes of the top heat sink in the vertical direction and arranging the heat pipes of the bottom heat sink in the horizontal direction; and arranging the heat pipes of the top heat sink and the heat pipes of the bottom heat sink in any two cross directions, to enable the heat pipes on the two heat sinks to make the temperature uniform in different directions. In one word, the larger heat dissipation capability can also enable the chips to operate at a higher frequency, thereby enhancing the computing power and improving the benefits of the whole machine.

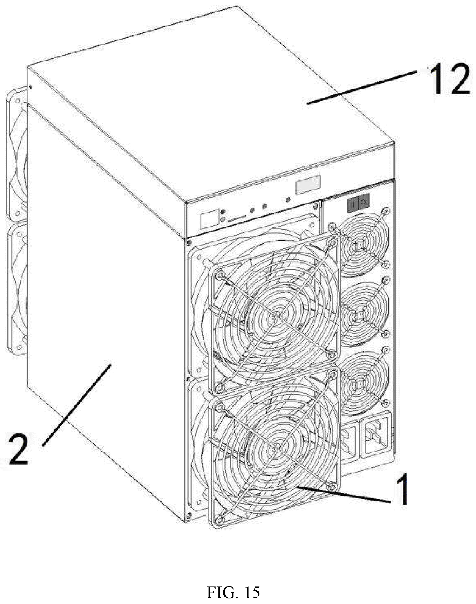

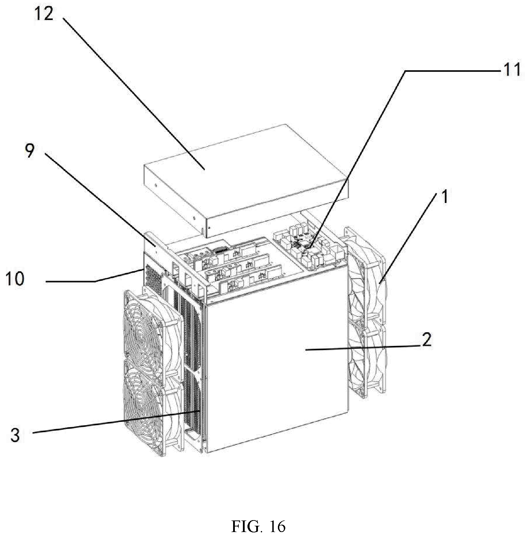

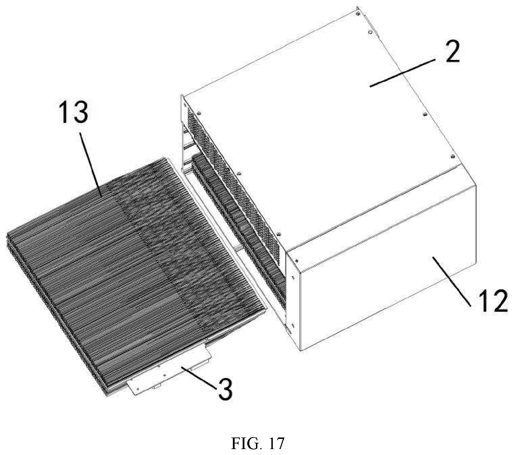

As shown in FIG. 15 through FIG. 17, they are schematic illustrations of a chassis having a heat pipe heat dissipation fin according to the present application. The chassis having a heat pipe heat dissipation fin comprises the chassis heat dissipation device 13 described above, the chassis further comprising:
a support 9 for supporting and fixing a chassis housing 2, fans 1, an upper cover 12, computing power units 3 and the chassis heat dissipation device 13, wherein the upper cover 12 and the chassis housing 2 constitute a chassis outer contour via the support 9; the chassis heat dissipation device 13 and various electronic elements are received in the chassis housing 2;
a power supply module 10 located beside the fan 1 on one side and connected with a circuit board and a control module in the chassis;
a control module 11 placed on the support 9 and located above the chassis housing 1 and below the upper cover 12 and configured to control the electronic elements in the chassis;
the chassis heat dissipation device 13 and the computing power units 3 are located behind the fans 1 to facilitate heat dissipation.

What are described above are only preferred embodiments of the present invention and not intended to limit the present invention. Those skilled in the art appreciate that the embodiments of the present invention may have various modifications or variations. Any modifications, equivalent substitutes, improvements etc. made within the spirit and principles of the present invention should all be included in the extent of protection of the present invention.

## Claims

1. A chassis heat dissipation device with a heat pipe heat dissipation fin, the device comprising: at least two axial flow fans (1) distributed on both sides of a chassis housing (2), a chassis housing (2) in which a computing power unit (3) is received , and at least one computing power unit (3), each computing power unit (3) comprising at least one circuit board (4), each computing power unit integrating a plurality of chips (5), the plurality of chips (5) being arranged side by side, multiple chips being directed into one group and coupled as one small unit, small units being coupled in series via wiring to form the circuit board (4), wherein
at least one heat sink (6) is placed on and under said each circuit board (4), the heat sink located on an upper side of the circuit board (4) is a top heat sink (61), the heat sink located on a lower side of the circuit board is a bottom heat sink (62), said each heat sink (6) includes a plurality of rows of heat dissipation fins (7) arranged in parallel, front ends of the top and bottom heat sinks are respectively at an outwardly chamfered angle, the angle is in a range of 20~50 degrees, the heat dissipation fin (7) forms a vertical angle with the circuit board (4), the top heat sink (61) directly presses against the chips on the circuit board (4), and the circuit board (4) is directly placed on the bottom heat sink (62) so that the circuit board (4) is sandwiched between the top heat sink and the bottom heat sink, the heat dissipation fins (7) and the circuit board in between are pressed and locked into one piece by spring screws, each chip on the circuit board is an independent heat generating unit, and the heat of the computing power unit (3) is transferred to the heat dissipation fins (7) and carried away by the flowing air;
the heat sink (6) is placed correspondingly on all chips (5) of the computing power unit (3), grooves having the same dimensions as the heat pipes (8) are machined in the bottom of the heat sink (6) by CNC milling, the heat sink (6) is electroplated to ensure solderability, a layer of solder paste is applied into the grooves, the heat pipes (8) are placed into the grooves, the heat pipes and the grooves are soldered into an integrated whole through high-temperature soldering, and then the bottom surface of the heat sink (6) is milled flat to ensure that the bottom of the heat pipe (8) and the bottom of the heat sink (6) are flat and even; the heat pipes (8) of the heat sink (6) are placed on the chips (5); the chips (5) are connected to the heat pipes (8) via a thermally conductive silicone grease which is filled into gaps between the heat pipes and the chips and gaps between the heat pipes and the circuit board (4), to ensure full contact between the chips and the heat sink; the heat pipes (8) are soldered with the heat sink (6) into the integrated whole;
the heat pipes (8) are evenly embedded in rows into the heat dissipation fins (7); the heat dissipation fins (7) and the heat pipes (8) are made of different materials;
the heat pipes assume a shape with a convex cross section; since a coefficient of thermal conductivity of the heat pipes is greater, the convex shape can increase a convex surface, i.e., increase a contact surface, on the basis of the heat pipe having an original thickness, and meanwhile a stepped groove hole fixes the position of the heat pipe more easily so that the heat pipe is not apt to deviate during the soldering and can stably carry more heat Q to the heat dissipation fins;
the heat pipes (8) embedded in the top heat sink (61) and bottom heat sink (62) are arranged in a crossed manner, i.e., after the top and bottom heat sinks sandwich the circuit board, the temperatures of all chips can be made uniform in different cross directions at the same time.

2. The chassis heat dissipation device with a heat pipe heat dissipation fin according to claim 1, wherein the heat of each chip of the computing power unit (3) is transferred to the top heat sink (61) and carried away by the flowing air; the heat of each chip is transferred via the circuit board to the bottom heat sink (62) and carried away by air.

3. The chassis heat dissipation device with a heat pipe heat dissipation fin according to claim 1, wherein the placing of the heat pipes (8) of the heat sinks (6) on the chips (5) comprises placing the top heat sink (61) and the bottom heat sink (62) respectively above each column/row of chips (5) of the computing power unit (3), subjecting a bottom surface of the top heat sink (61) and a bottom surface of the bottom heat sink (62), which respectively contact the circuit board (4), to an electroplating process, and enabling the heat pipes (81) of the top heat sink (61) to be placed exactly above the chips (5); the heat pipes (82) of the bottom heat sink (62) are evenly distributed exactly below the chips (5).

4. The chassis heat dissipation device with a heat pipe heat dissipation fin according to claim 1, wherein the heat dissipation fin is made of aluminum, and a coefficient of thermal conductivity k of aluminum is 200W/m.k.

5. The chassis heat dissipation device with a heat pipe heat dissipation fin according to claim 4, wherein the heat pipes are made of copper, and a coefficient of thermal conductivity k of copper is in a range of 20000W/m.k~200000W/m.k, which is 100 to 1000 times the coefficient of thermal conductivity of aluminum, and the heat pipes make the temperature difference on the chips uniform quickly and can carry more heat to the heat dissipation fin made of aluminum.

6. The chassis heat dissipation device with a heat pipe heat dissipation fin according to claim 5, wherein at least one heat pipe soldered to the bottom of the heat sink extends from one side thereof and is bent along the edge of the heat sink and then inserted back into the heat dissipation fins; a perforation is reserved at a middle portion of a lateral side of the heat dissipation fins to allow the bent heat pipe to be inserted therein; since the heat dissipation fin has a certain height, a temperature difference exists between its top and bottom, and the temperature at the top is lower; the heat pipe bent and inserted back into the heat dissipation fins can carry heat to a low-temperature region closer to the top of the heat dissipation fins.

7. The chassis heat dissipation device with a heat pipe heat dissipation fin according to claim 6, wherein the heat pipe is bent into the heat sink in a U-shape, with one side of the U-shape being located at the bottom of the heat sink in contact with the chips and the other side of the U-shape being located in the heat dissipation fin.

8. The chassis heat dissipation device having a heat pipe heat dissipation fin according to claim 1, wherein the arranging the heat pipes (8) embedded in the top heat sink (6) and bottom heat sink (62) in a crossed manner comprises:
arranging the heat pipes of the top heat sink in a horizontal direction and arranging the heat pipes of the bottom heat sink in a vertical direction to carry heat away from the heat dissipation fins in the horizontal direction and vertical direction, respectively;
arranging the heat pipes of the top heat sink in the vertical direction and arranging the heat pipes of the bottom heat sink in the horizontal direction; and arranging the heat pipes of the top heat sink and the heat pipes of the bottom heat sink in any two cross directions, to enable the heat pipes on the two heat sinks to make the temperature uniform in different directions.

9. A chassis with a heat pipe heat dissipation fin, wherein the chassis heat dissipate device (13) according to any of claims 1-8 is applied to the chassis, and the chassis further comprises:
a support (9) for supporting and fixing a chassis housing (2), a fan (1), an upper cover (12), a computing power unit (3) and the chassis heat dissipation device (13), wherein the upper cover (12) and the chassis housing (2) constitute a chassis outer contour via the support (9);
the chassis heat dissipation device (13) and various electronic elements are received in the chassis housing (2);
a power supply module (10) located beside the fan (1) on one side and connected with a circuit board and a control module in the chassis;
a control module (11) placed on the support (9) and located above the chassis housing (2) and below the upper cover (12) and configured to control the electronic elements in the chassis;
the chassis heat dissipation device (13) and the computing power units (3) are located behind the fan (1) to facilitate heat dissipation.
